# EUROPÄISCHE PATENTANMELDUNG

(11) **EP 2 600 168 A1**
(43) Veröffentlichungstag der Anmeldung: **05.06.2013**
(21) Anmeldenummer: 11191588.0
(22) Anmeldetag: 01.12.2011
(51) Int. Cl.: G01S 7/481

(54) **Entfernungsmesser**

(71) Anmelder: Leica Geosystems AG, 9435 Heerbrugg (CH)
(72) Erfinder: Giger, Kurt, 9464 Rüthi (CH); Metzler, Reto, 9445 Rebstein (CH); Fiegl, Bernhard, CH-9437 Marbach (CH)
(74) Vertreter: Gyaja, Christoph Benjamin

(57) **Zusammenfassung**

Die Erfindung betrifft einen optoelektronischen Entfernungsmesser mit einer Sendeeinheit, einer Empfangseinheit einer elektronischen Auswerteeinheit.

Die Sendeeinheit hat eine Leiterplatte, einen Halbleiterlaser und einen Lasendiodentreiber, zur Aussendung von hochfrequent intensitätsmodulierter optischer Strahlung.

Die Empfangseinheit ist zum Empfang eines von einem Zielobjekt zurückgeworfenen Anteils der optischen Strahlung durch ein photosensitives elektrisches Bauelement mit einem elektrischen Ausgangssignal als Empfangssignal, einer Konditioniereinheit zur Konditionierung des Empfangssignals und einem Analog-Digital-Wandler zur Digitalisierung des konditionierten Empfangssignals ausgestattet.

Die elektronischen Auswerteeinheit ermittelt auf Basis einer Signallaufzeit anhand des digitalisierten Empfangssignals eine Distanz vom Entfernungsmesser zum Zielobjekt.

Der Halbleiterlaser ist dabei als gehäuseloses Lasersubstrat, auf die Leiterplatte aufgebracht.

## Beschreibung

Die Erfindung betrifft einen Entfernungsmesser nach dem Oberbegriff des Anspruchs 1, speziell eine Sendeeinheit eines solchen Entfernungsmessers, und ein Verfahren zur Herstellung einer Sendeeinheit nach dem Oberbegriff des Anspruchs 12.

Bei optoelektronischen Distanzmessern (EDM) wird ein optisches Signal vom Gerät in Richtung des Zielobjekts - dessen Distanz es zu bestimmen gilt - ausgesendet, beispielsweise als optische Strahlung in Form von Laserlicht. Um den zur Vermessung angezielten Punkt auf dem Zielobjekt erkennbar zu machen, wird dabei vielfach sichtbares Licht verwendet. Die Oberfläche des Zielobjekts wirft zumindest einen Teil des optischen Signals zurück, meist in Form einer diffusen Reflektion. Die zurückgeworfene optische Strahlung wird im Gerät von einem photosensitiven Element in ein elektrisches Signal umgewandelt. Unter Kenntnis der Ausbreitungsgeschwindigkeit des optischen Signals und anhand der ermittelten Laufzeit, welche für das Zurücklegen der Entfernung vom Gerät zum Zielobjekt und retour benötigt wird, kann die Distanz zwischen Gerät und Zielobjekt bestimmt werden. Vielfach befinden sich dabei im optischen Sende- bzw. Empfangspfad optische Komponenten zur Strahlformung, Umlenkung, Filterung, etc. - wie etwa Linsen, Wellenlängenfilter, Spiegel, usw.

Zur Kompensation von Einflüssen, welche die Messergebnisse verfälschen könnten (beispielsweise Temperatureinflüsse, Bauteiltoleranzen, Driften von elektronischen Komponenten, etc.), kann ein Teil des ausgesendeten optischen Signals als Referenzsignal über eine Referenzstrecke bekannter Länge von der Lichtquelle zum lichtempfindlichen Empfangselement geführt werden. Die Referenzstrecke kann dabei fix im Gerät eingebaut oder als ein beispielsweise einschwenkbares oder aufsteckbares Umlenkelement ausgebildet sein. Das von diesem Referenzsignal resultierende Empfangssignal kann von dem zur Messung verwendeten oder einem dezidierten photosensitiven Element empfangen werden. Das resultierende elektrische Referenzsignal kann zur Referenzierung und/oder Kalibrierung der ermittelten Messwerte herangezogen werden.

Um eine entsprechend hohe Genauigkeit der Distanzmessung zu erlangen, sind aufgrund der hohen Ausbreitungsgeschwindigkeit von optischer Strahlung die Anforderungen an das zeitliche Auflösungsvermögen zur Distanzmessung recht hoch. Beispielsweise ist für eine Distanzauflösung von 1 mm eine Zeitauflösung mit einer Genauigkeit von etwa 6,6 Pico-Sekunden erforderlich.

Bezüglich der emittierbaren Signalleistung sind den hier behandelten optoelektronischen EDM Grenzen vorgegeben. So bestimmt bei der Emission von Laserlicht die Augensicherheit eine maximal zulässige mittlere Signalleistung, welche emittiert werden darf. Um für die Messung dennoch hinreichend starke Signalintensitäten zu erhalten, welche vom Empfänger detektierbar sind, wird daher im Pulsbetrieb gearbeitet. Das ausgesendete optische Signal ist in seiner Intensitätsamplitude moduliert. Es werden kurze Pulse mit hoher Spitzenleistung gefolgt von Pausen ohne Signalaussendung emittiert. Somit weist der zurückgeworfene Anteil der Pulse eine genügend hohe Intensität auf, um diese aus den Hintergrundstörungen und dem Rauschen, insbesondere auch bei Vorhandensein von Hintergrundlicht (Sonnenlicht, künstlicher Beleuchtung, etc.), auswerten zu können.

Wie etwa in EP 1 957 668 beschrieben birgt speziell das Aussenden von Paketen von Pulsen gefolgt von Pausen ohne Pulsaussendung - dem sogenannten Burst-Betrieb - nicht nur den Vorteil einer reduzierten mittleren Leistung des Signals, sondern zudem auch Vorteile beim erzielbaren Signal-Rausch-Verhältnis (SNR). Einerseits kann hierdurch die Signalintensität während der aktiven Burst-Zeit entsprechend höher sein als bei einem kontinuierlichen Aussenden - ohne dabei die mittlere Leistungsgrenze zu überschreiten. Andererseits wird auch das Rauschen nur in den Zeitfenstern während der aktiven Burstsdauer aufgenommen - jedoch nicht während der Austastlücken, da während dieser keine Signalauswertung erfolgt. Durch ein Tastverhältnis (oder Duty-Cycle) der Bursts z.B. von 0.1 bzw. 1:10 oder 10% (10% der Burstdauer Signalemission + 90% Pause) lässt sich somit eine Verbesserung des SNR von etwa Quadratwurzel aus 1/Duty-Cycle erzielen, im Beispiel von 10% also eine Verbesserung um einen Faktor von mehr als 3. Die Anzahl der Pulse pro Paket kann je nach Auswertekonzept und Messsituation variiert werden bis hin zu einzelnen Pulsen (wobei dann im Allgemeinen nicht mehr von Bursts gesprochen wird).

Zur Ermittlung der Laufzeit des Signals ist zum einen die sogenannte Time-of-Flight (TOF) Methode bekannt, welche die Zeit zwischen dem Aussenden und Empfangen eines Lichtpulses ermittelt, wobei die Zeitmessung anhand der Flanke, des Spitzenwert oder einer anderen Charakteristik der Pulsform erfolgt. Unter Pulsform ist dabei ein zeitlicher Lichtintensitätsverlauf des Empfangssignals, speziell des empfangenen Lichtpulses - erfasst durch das photosensitive Element - zu verstehen. Dabei kann der Zeitpunkt des Sendens entweder anhand eines elektrischen Auslöseimpulses, des an den Sender angelegten Signals oder anhand des oben erwähnten Referenzsignals ermittelt werden.

In der Distanzmessung kann es zu Mehrdeutigkeiten kommen, falls die Signallaufzeit den Kehrwert der Puls- oder Burst-Senderate übersteigt und somit mehrere Signale zugleich zwischen Gerät und Messobjekt unterwegs sind, wodurch ein Empfangspuls oder Empfangsburst nicht mehr eindeutig seinem jeweiligen Sendepuls oder Sendeburst zugeordnet werden kann. Es ist somit ohne weitere Maßnahmen unklar, ob tatsächlich die bestimmte Distanz oder ein ganzzahliges Vielfaches dieser gemessen wurde.

Zum anderen ist das sogenannte Phasenmessprinzip bekannt, welches die Signallaufzeit durch Vergleich der Phasenlage der Amplitudenmodulation des gesendeten und empfangenen Signals ermittelt. Dabei hat das Messergebnis bei einer Sendefrequenz aber Mehrdeutigkeiten in Einheiten der Signalperiodendauer, sodass weitere Maßnahmen zur Auflösung dieser Mehrdeutigkeiten erforderlich sind. Beispielsweise zeigt WO 2006/063740 ein Messen mit mehreren Signalfrequenzen welche in unterschiedlichen Eindeutigkeitsbereichen resultieren, wodurch falsche Lösungen ausgeschlossen werden können. Auch WO 2007/022927 behandelt Eindeutigkeiten in der Phasenmessung.

Der beschriebene Puls- oder Burst-Betrieb des Distanzmessers erfordert das Aussenden von kurzen Lichtpulsen, also eine hohe Modulationsfrequenz des emittierten Lichts. Beispielhaft sei das im folgenden mit konkreten Zahlenwerten aufgeführte EDM-Design als eine mögliche, konkrete Ausführungsform dargelegt. Die dabei verwendeten Zahlenwerte sind dabei primär als Richtwerte für die Größenordnungen und -verhältnisse der Signale zueinander anzusehen und nicht als abschließende, limitierende Werteangaben. Die hierbei angegebenen Größenordungen und Zahlenwerte sind rein beispielhaft, um eine erfindungsgemäß gelöste Problemstellung zu Illustrieren. Praktische Beispiele von Modulationsfrequenzen in EDMs liegen im 100 MHz bis 10 GHz Bereich, speziell etwa bei 500 MHz bis 1 GHz. Bei Sendeelementen in Form von Halbleitern wird dieses durch eine entsprechend schnelle, elektrische Ansteuerung erzielt. Um dabei die geforderte hohe Spitzenleistung der optischen Pulse zu erreichen, müssen daher von Lasertreiber kurze elektrische Impulse mit hohen Stromstärken in die Lichtquelle eingeprägt werden.

Beispielsweise sind Impulsdauern im Bereich von Nanosekunden oder darunter, speziell etwa von 1 bis 0,1 Nanosekunden oder darunter, gebräuchliche Werte. Die dabei einzuprägenden Spitzenströme sind dabei etwa im Bereich von etlichen Milliampere, beispielsweise etwa 10 mA bis 1 A, speziell etwa 50 bis 300 mA. Bei einem beispielhaften Strompuls mit Dreiecksform und einem Spitzenwert von 100 mA mit einer Dauer von 1 ns ergibt dieses einen Stromanstieg in einer Größenordung von 10⁸ Ampere pro Sekunde. Bei einer Gesamtinduktivität des Ansteuerkreises (insbesondere mit Laserdiode, Zuleitungen, Ansteuerschaltung) von 10 nH ergibt dieses bereits einen Spannungsabfall in der Größenordung der Laserthreshold-Spannung der Laserdiode (von z.B. typisch etwa 2.3V bei roten Laserdioden). Um beispielsweise einen annähernd rechteckförmigen optischen Puls zu generieren, sind die Anforderungen entsprechend noch höher, sodass sich schon wenige Nano-Henry an Zuleitungsinduktivität in der emittierten Pulsform bemerkbar machen. Gewöhnliche Gehäuseanschlüsse von Laserdioden-Bauelementen sowie die Bonddrähte im Bauteil selbst weisen jedoch vielfach schon eine Induktivität in der Größenordnung von 5 bis 10 nH auf, haben also einen beträchtlichen Anteil am induktiven Verhalten des Ansteuerungs-Schaltkreises.

Besonders im Rahmen der Verwendung eines Lasertreibers wie er beispielsweise in der europäischen Patentanmeldung Nr. 11180282 (deren Inhalt durch Bezugnahme hierin aufgenommen wird) gezeigt wird, ist eine geringe Zuleitungskapazität der Laserdiode von Bedeutung. Durch das darin verwendete Ansteuerprinzip mit einer Versorgungsspannung unterhalb der Laserthresholdspannung, wirken sich parasitäre Induktivitäten der Laserdiode oder genauer genommen deren Zuleitungen noch problematischer aus als in konventionellen Lasertreibern. Aber auch bei konventionellen Laserdiodentreibern wirkt sich eine geringe Induktivität der Laserdiode und deren elektrischen Anschlüssen positiv aus. Neben einer messtechnischen Erfassung dieser Problematik wird auf die Thematik der Zuleitungsinduktivität beim Pulsbetrieb von Laserdioden beispielsweise auch in der TechNote TN #36000-2 der Firma ILX Lightwave (www.ilxlightwave.com) eingegangen, wobei die darin beschriebenen Dimensionen und Leistungsklassen im technischen Gebiet der Entfernungsmesser nicht zutreffen. Speziell für handgehaltene, kompakte, batteriebetriebene EDMs ist die darin präsentierte Lehre nicht anwendbar, insbesondere da die Leistungsklassen gänzlich anders sind und ohnehin keine darin beschriebenen Standard-Anschlusskabel Verwendung finden.

Die Laserdioden nach dem Stand der Technik, etwa wie in US 7.192,201 beschrieben, weisen Aufbaubedingt eine für den hier beschriebenen Anwendungsfall recht hohe parasitäre Induktivität auf. Konträr zur vorliegenden Anmeldung wird in diesem Dokument sogar das Einbringen einer Induktivität in die Laserdiode beschrieben.

Bei derartigen im Stand der Technik angewendeten Laserdioden ist die parasitäre Induktivität bauartbedingt hoch, speziell durch die verhältnismäßig langen Zuleitungen, Bonddrähte, etc. Für hochfrequent modulierte EDM sind die induktiven Eigenschaften dieser Bauelemente merklich störend und im Rahmen einer Optimierung des EDM-Systems nicht zu vernachlässigen.

Eine weiterer limitierender Faktor bezüglich der Erreichung hoher Distanzgenauigkeiten im Stand der Technik sind auch Übersprecheffekte in der Elektronik. Hierbei ist zum einen der Sender mit den anwendungsbedingt gewünschten, kurzen Pulsen mit hohen Amplitudenwerten eine potenzielle, breitbandige Störquelle. Die Anschlüsse wirken dabei als "Sendeantennen", welche diese elektromagnetischen Störungen emittieren.

Es ist eine Aufgabe der vorliegenden Erfindung, einen optoelektronischen Distanzmesser zu verbessern, insbesondere eine Erhöhung der Distanzmessgenauigkeit, der Messrate und/oder eine Steigerung der Signalqualität der ausgesendeten Lichtpulse zu erreichen.

Eine Aufgabe ist dabei die Aussendung von Lichtpulsen im EDM zu verbessern, insbesondere auch in Bezug auf das Reduzieren von elektromagnetischen Störaussendungen, auch zur Verbesserung des erzielbaren Signal/Rausch-Verhältnis der Distanzmessung.

Die Verbesserung und Vereinfachung der Sendeeinheit eines Entfernungsmessers ist eine weitere Aufgabe, speziell unter ökonomischen Gesichtspunkten, wie vereinfachtes Assembling bei der Geräteproduktion, Miniaturisierung, Reduktion von Komponentenanzahl und Komponentenkosten.

Als spezielle Aufgabe ist dabei insbesondere eine Sendeeinheit mit einem monitordiodenlosen Lasertreiber zu optimieren. Es ist dabei auch eine Teilaufgabe geringere Ansteuerspannungen verwenden zu können.

Als weitere Teilaufgaben stellen sich dabei die Erzielung einer vorteilhaften Montage und geometrischen Anordnung für die Halbleiter-Lichtquelle auf der Leiterplatte, insbesondere in Hinblick auf die Einhaltung von Maßtoleranzen, Vermeidung von Abschattung des emittierten Lichtstrahls und/oder mechanisch geschützte Positionierung der Lichtquelle am Rande der Leiterplatte.

Ein erfindungsgemäßer optoelektronischer Entfernungsmesser, insbesondere ein Laser-Distanzmesser, auch als EDM (Elektronischer Distanz Messer) oder LRF (Laser Range Finder) bezeichnet, ist zur erfindungsgemäßen Lösung dieser Aufgaben aufgebaut mit:
■ Einer Sendeeinheit mit einer Leiterplatte, einem Halbleiterlaser und einem Laserdiodentreiber zur Aussendung von hochfrequent intensitätsmodulierter optischer Strahlung. Die hochfrequente optische Strahlung kann dabei insbesondere als burstmodulierte Strahlung mit einer Burstrate, einem Burst-Tastverhältnis und einer Pulsfrequenz innerhalb eines Bursts oder auch als einzelne oder kontinuierlich aufeinander folgende Lichtpulse von kurzer Zeitdauer ausgeformt sein.
■ Einer Empfangseinheit zum Empfang eines von einem Zielobjekt zurückgeworfenen Anteils der optischen Strahlung durch ein photosensitives elektrisches Bauelement mit einem elektrischen Ausgangssignal als Empfangssignal. Das photosensitive Bauelement kann insbesondere eine Photodiode, speziell eine APD sein. Die Empfangseinheit ist auch mit einer Konditioniereinheit zur Konditionierung des Empfangssignals und einem Analog-Digital-Wandler zur Digitalisierung des konditionierten Empfangssignals ausgestattet.
■ Einer elektronischen Auswerteeinheit, welche auf Basis einer Signallaufzeit anhand des digitalisierten Empfangssignals eine Distanz vom Entfernungsmesser zum Zielobjekt ermittelt.

Erfindungsgemäß ist der Halbleiterlaser als gehäuseloses Lasersubstrat sozusagen direkt auf die Leiterplatte aufgebracht. Insbesondere kann der Halbleiterlaser elektrisch leitend aufgebracht sein. Beispielsweise kann dabei das Lasersubstrat auch direkt mit einem Bonddraht elektrisch mit der Leiterplatte oder dem Laserdiodentreiber verbunden sein.

Dabei sind sozusagen das Lasersubstrat und zumindest ein Leistungsteil oder eine Endstufe des Laserdiodentreibers auf derselben Leiterplatte angeordnet.

Dabei kann das Lasersubstrat am Rande eines durch einen Leiterplattenrand geteilten Loches platziert sein, um die mechanische Positionsgenauigkeit zu erhöhen und ein teilweises Verdecken des Emissionswinkels zu verhindern, sowie auch um mechanischen Schutz für die emittierende Stirnfläche zu bieten. Das Loch kann dabei ein bei der Leiterplattenherstellung gebohrtes Loch sein, wie dieses etwa auch als Standardprozess für die Durchsteckmontage von elektronischen Bauteilen mit hoher Positionsgenauigkeit üblich ist. Der Rand der Leiterplatte kann dabei mit geringerer Genauigkeit geritzt, gefräst oder lasergeschnitten sein.

Das Lasersubstrat hat einen ersten und einen zweiten elektrischen Anschluss, welche beide elektrisch mit dem Lasertreiber verbunden werden.

Beim Lasersubstrat kann eine erste Halbleiterschicht als erster Anschluss in einem Teilbereich dieser Halbleiterschicht insbesondere chemisch oder mechanisch (z.B. durch Ätzen, Fräsen, Schleifen, Lasergravieren, etc.) entfernt sein, sodass ein Teil der gegenüberliegenden zweiten Halbleiterschicht als zweiter Anschluss freigelegt und kontaktierbar ist. Das Lasersubstrat kann somit von der Seite der ersten Halbleiterschicht am ersten und zweiten Anschluss kontaktiert werden. Dabei kann insbesondere das Lasersubstrat als sogenannter Flip-Chip elektrisch leitend auf der Leiterplatte oder dem Lasertreiber anbringbar sein, im speziellen, wobei der erste und zweite Anschluss mit zumindest einem Ball-Kontakt versehen sein können und mittels diesem konduktiv auf die Leiterplatte oder den Lasertreiber aufklebbar oder auflötbar sind.

Das Lasersubstrat kann als erster Anschluss elektrisch leitend auf der Leiterplatte aufgebracht sein, beispielsweise geklebt, gebondet oder elektrisch leitend auf die Leiterplatte aufgelötet sein. Dabei kann gegebenenfalls ein isolierendes oder leitendes Zwischenelement Anwendung finden.

Das Lasersubstrat kann als zweiter Anschluss mit einem Bonddraht auf die Leiterplatte kontaktiert sein oder mit einem elektrisch leitenden Kontaktstreifen, insbesondere einem federnden Element, auf die Leiterplatte kontaktiert sein.

Das Lasersubstrat kann in einer Ausführungsform auch mit den Anschlüssen seitlich - also sozusagen hochkant - in einen Schlitz in der Leiterplatte eingebracht werden und seitlich jeweils von Leiterbahnen kontaktiert werden, insbesondere durch Verlöten oder konduktives verkleben. Das Lasersubstrat kann in einer anderen Ausführungsform auch zwischen zwei Kontakten auf der Leiterplatte eingesteckt werden, welche (z.B. etwas federnd) den ersten und zweiten Anschluss kontaktieren. Die Kontakte können auch die Positionierung sicherstellen und das eingesteckte Lasersubstrat kann z.B. durch Kleben zwischen den Kontakten fixiert werden. Dabei können die Kontakte auch als Kühlkörper für das Lasersubstrat fungieren.

Die Leiterplatte kann zudem zur Ableitung von Abwärme des Lasersubstrats konfiguriert sein, insbesondere mit entsprechenden Leiterbahnflächen, Vias zur Ableitung und Verteilung der Wärme in untere Leiterbahnschichten und/oder mittels eines auf der Leiterplatte angebrachten (z.B. aufgelöteten) Kühlkörpers.

Gemäß eines Teils der Erfindung erfolgt die Kontaktierung des Halbleitersubstrats derart, dass deren Zuleitungsimpedanz gegenüber einer gehäusegekapselten Laserdiode verringert ist, insbesondere durch eine verkürzte Zuleitungslänge vom Lasertreiber zu einem elektrischen Anschluss des Lasersubstrats, beispielsweise durch direktes Bonding des Anschlusses des Lasersubstrats auf die Leiterplatte oder den Lasertreiber.

Die Sendeeinheit kann entsprechend einer Ausführungsform monitordiodenlos ausgeführt sein. Dabei werden monitordiodenlos die Lasersicherheitsrichtlinien erfüllt, beispielsweise indem der Lasertreiber mit einer Versorgungsspannung unterhalb eines Laserthresholds des Halbleiterlasers betrieben wird. Speziell in einer solchen Konstellation kann die Zuleitungsimpedanz zum lichtemittierenden Halbleiter für die Erzeugung kurzer Lichtpulse von Bedeutung sein.

Erfindungsgemäß wird auch eine Sendeeinheit, insbesondere zum hochfrequenten Pulsbetrieb einer Laserdiode für einen erfindungsgemäßen Entfernungsmesser mit einer Leiterplatte als Trägerelement, einem Lasertreiber als elektronischem Schaltkreis und einem gehäuselosen Halbleiterlaser-Substrat, welches auf der Leiterplatte aufgebracht ist, beschreiben. Das Halbleiterlaser-Substrat kann dabei insbesondere direkt auf die Leiterplatte aufgebracht sein. Die Sendeeinheit kann dabei eine vormonierte Baugruppe des EDMs sein.

Die Erfindung betrifft demzufolge auch ein Verfahren zur Herstellung einer solchen Sendeeinheit. Das Verfahren beinhaltet dabei zumindest
■ ein Herstellen einer Leiterplatte der Sendeheinheit,
■ ein Aufbringen der Halbleiterlichtquelle als gehäuseloses Lasersubstrat auf die Leiterplatte, beispieslweise durch konduktives Kleben, Löten oder Friction-Bonding, und
■ ein Kontaktieren zumindest eines elektrischen Anschlusses des Lasersubstrats auf die Leiterplatte mittels eines Die-Bonding-Vorgangs, beispielsweise mittels zumindest eines Bonddrahtes.

Das Verfahren, speziell das Aufbringen der Halbleiterlichtquelle, kann auch mit einem Positionieren der Halbleiterlichtquelle am Rande einer stirnseitigen Einbuchtung, insbesondere am Rande eines Segments einer Bohrung der Leiterplatte erfolgen.

Die Erfindung betrifft weiterhin ein Verfahren zur Reduktion einer Impedanz, insbesondere einer parasitären Zuleitungsinduktivität, einer Halbleiterlichtquelle in einer Sendeeinheit eines EDMs, mit welcher hochfrequente, steilflankige Lichtpulse aussendbar sind, indem ein Aufbringen der Halbleiterlichtquelle als gehäuseloses Lasersubstrat auf eine Leiterplatte erfolgt (z.B. durch konduktives Kleben, Löten, Friction-Bonding, etc.).

Dabei kann ein direktes Kontaktieren zumindest eines elektrischen Anschlusses des Lasersubstrats auf die Leiterplatte mittels eines Die-Bonding-Vorgangs erfolgen, insbesondere mittels zumindest eines Bonddrahts.

Eine optoelektronische Distanzmessung unter Anwendung des beschriebenen Burst-Prinzips kann auch dahingehend genutzt werden, eine Auswertung mit gleichzeitiger Grob und Feinmessung durchzuführen. Wie beschrieben eignet sich eine TOF-Messung von Lichtpulsen oder Pulspaketen bei entsprechend hohem zeitlichen Pulsabstand gut, um eine eindeutige Distanzmessung zu erhalten, jedoch ist dabei eine hochauflösende Zeitmessung eines einzelnen Pulses innerhalb des Paktes nur bedingt realisierbar, weshalb dieses als Grobmessung bezeichnet wird.

Im Gegensatz dazu lässt sich durch eine sogenannte Feinmessung mittels Digitalisierung der Pulsform der einzelnen Pulse und Bestimmung der Phasenlage eines oder mehrerer Pulse eine hohe Zeitauflösung erzielen. Diese ist aber bei größeren Messbereichen aufgrund der Signalperiodizität nicht eindeutig einer einzigen Distanz zuordenbar, sondern meist mehrdeutig.

Zur Feinmessung kann weiters das Sendesignal zyklisch, beispielsweise pro Burst-Intervall, mit einem Phasenversatz gegenüber dem - wie beschrieben - synchronisierten Empfänger emittiert werden. Ein derartiger Versatz kann z.B. mit einer PLL- oder DLL-Einheit in der Sendeeinheit lokal im Sender generiert werden, beispielsweise als ein Phasenversatz um jeweils einen bestimmten Teil der Periode der Sendefrequenz. Pro Phasenversatz wird somit die Pulsform vom Empfänger an einer anderen Stelle innerhalb des Pulses abgetastet, was eine erhöhte Auflösung der Pulsform bewirkt (vergleichbar mit der zeitgedehnten Darstellung von periodischen Signalen bei Oszilloskopen mit ETS-Sampling - wobei hier jedoch der Sender und nicht der Empfänger verschoben wird). Durch die beschriebene Trennung von Sender und Empfänger kann dabei das Übersprechen trotz Phasenversatz gering gehalten werden. Der Wechsel des Phasenversatzes kann jeweils zu Zeitpunkten geschehen, zu welchen keine Signale emittiert werden, also beispielsweise zwischen den aktiven Bursts. Allfällige Einschwing- oder Stabilisationsvorgänge durch den Phasenversatz haben somit keinen Einfluss auf das emittierte Signal, da diese quasi vom Sendesignal ausgeblendet sind.

In anderen Worten führt der Entfernungsmesser eine Grobmessung der Distanz anhand der Laufzeit zwischen einem Aussenden eines Bursts und einem Empfangen des Bursts durch, z.B. anhand einer Hüllkurve des Bursts, beispielsweise mit einer Distanzgenauigkeit größer 10 cm. Weiters erfolgt eine Feinmessung der Distanz, z.B. anhand einer binären Korrelation von zumindest zwei Signalformen der Modulation innerhalb des Bursts, beispielsweise mit einer Distanzgenauigkeit von kleiner 10 cm, insbesondere kleiner 1 cm, beispielsweise etwa von 1 mm, durch. Dabei erfolgt die Grob- und Feinmessung zur Ermittlung der Distanz anhand desselben burstmodulierten Signals, also im Rahmen derselben Messung. Speziell ist dabei anhand der Grobmessung eine Eindeutigkeit der mittels Feinmessung ermittelten Distanz bestimmbar.

Entsprechend der vorliegenden Erfindung können Grobmessung und Feinmessung gleichzeitig durchgeführt werden. Zum einen kann dabei ein oder mehrere Burst-Pakete - oder auch die Hüllkurve der Burst-Pakete - als ganzes zur Grobmessung herangezogen werden (mit einer von der Burst-Wiederholfrequenz abhängigen Eindeutigkeit), während gleichzeitig die höherfrequente Modulation innerhalb eines oder mehrerer Bursts zur Feinmessung mit geringeren Eindeutigkeitslängen aber erhöhter Messgenauigkeit Verwendung finden kann. Dadurch kann mit einer Messung eine genaue und eindeutige Distanz bestimmt werden. Dieses erlaubt schnellere Messungen, da zur Eindeutigkeitsbestimmung nicht auf die im Stand der Technik bekannten Mehrfrequenzmessungen mit mehreren Sende/Mischfrequenzen (siehe z.B.: WO 2006/063740) oder ähnliche Prinzipien zurückgegriffen werden muss. Derartige Prinzipien können aber weiterhin, etwa zur Verbesserung der Robustheit der Messung, Anwendung finden.

Speziell kann dabei auch das Burst-Paket gegenüber der Abtastfrequenz zyklisch (beispielsweise jeweils während der Burst-Pausen) phasenverschoben werden, wodurch im Empfänger nur synchrone Signale und somit geringeres Übersprechen vorhanden sind, da nur noch in der Endstufe des Senders zur Auswertung phasenverschobene Signale auftreten. Dieser Schaltungsteil lässt sich entsprechend gut EMV-technisch trennen und optimieren sowie auch erfindungsgemäß bezüglich seines EMV-Abstrahlverhaltens verbessern.

Der erfindungsgemäße Aufbau der Sendeeinheit bietet Vorteile bezüglich der Störaussendung, da anhand dieser zugleich auch die als störabstrahlende Antennen wirkenden elektrischen Zuleitungen zur Lichtquelle optimiert, beispielsweise verkürzt, mit einem breiteren Leiterquerschnitt versehen und/oder durch sogenanntes GuardBanding über weite Strecken geschirmt werden können.

Das erfindungsgemäße Verfahren und die erfindungsgemäße Vorrichtung werden nachfolgend anhand von in den Zeichnungen schematisch dargestellten, konkreten Ausführungsbeispielen rein beispielhaft näher beschrieben, wobei auch auf weitere Vorteile der Erfindung eingegangen wird. Im einzelnen zeigen:
Fig. 1 eine erste Ausführungsform eines erfindungsgemäßen Entfernungsmessers als Block-Schema;
Fig. 2a eine beispielhafte Darstellung einer bekannten Sendeeinheit eines EDMs;
Fig. 2b eine beispielhafte Darstellung einer bekannten Laserdiode, welche im Stand der Technik in EDMs eingesetzt wird;
Fig. 3 eine beispielhafte, schematische Darstellung zur Erläuterung des Prinzips einer erfindungsgemäßen EDM-Sendeeinheit;
Fig. 4a eine beispielhafte erste Ausführungsform einer erfindungsgemäßen Sendeeinheit eines EDMs;
Fig. 4b eine beispielhafte Ausführungsform eines Halbleiterlasers zur Flip-Chip-Montage auf einer erfindungsgemäßen EDM-Sendeeinheit;
Fig. 5 eine beispielhafte zweite Ausführungsform einer erfindungsgemäßen Sendeeinheit eines EDMs;
Fig. 6 eine beispielhafte dritte Ausführungsform einer erfindungsgemäßen Sendeeinheit eines EDMs;
Fig. 7a eine beispielhafte vierte Ausführungsform einer erfindungsgemäßen Sendeeinheit eines EDMs;
Fig. 7b eine beispielhafte fünfte Ausführungsform einer erfindungsgemäßen Sendeeinheit eines EDMs.
Fig. 8 eine beispielhafte sechste Ausführungsform einer erfindungsgemäßen Sendeeinheit eines EDMs.

Die Darstellungen in den Figuren dienen lediglich zur Illustration und sind nicht als maßstäblich zu betrachten.

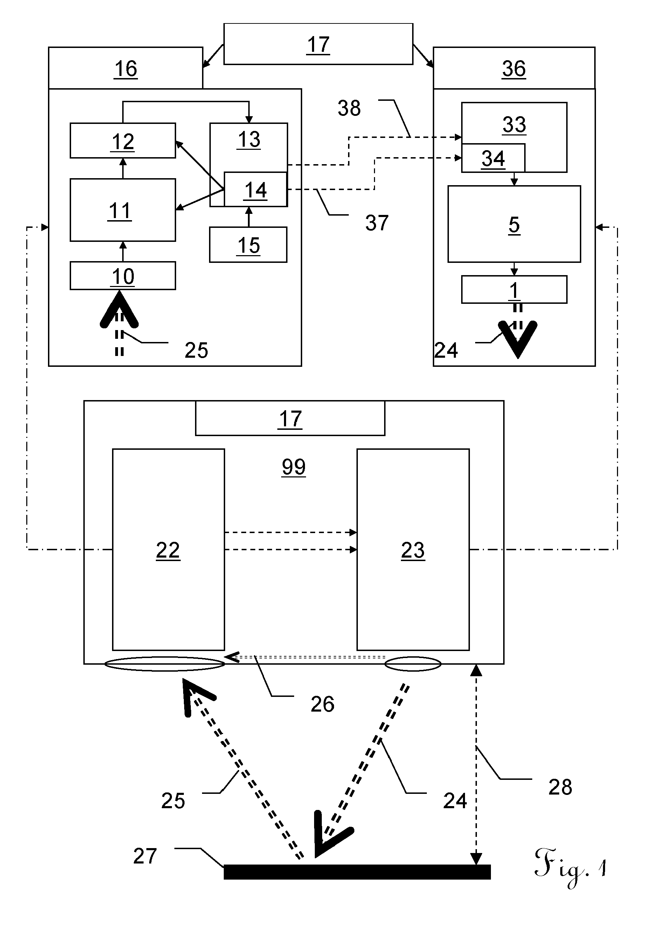

**Fig. 1** zeigt eine Ausführungsform eines erfindungsgemäßen optoelektronischen Distanzmessers 99 als Blockdiagramm. Es kann sich dabei beispielsweise um einen handgehaltenen, batteriebetriebenen Entfernungsmesser oder ein anderes Vermessungsgerät handeln, wie diese beispielsweise Vielfältig im Baustellenbereich eingesetzt werden. In der unteren Hälfte der Figur sind die beiden, entsprechend eines Teils der Erfindung getrennten Blöcke der Sendeeinheit 23 und der Empfangseinheit 22 dargestellt, welche durch entsprechende Maßnahmen voneinander EMItechnisch getrennt sein können, beispielsweise durch eine EMI-Barriere. Die dargestellte Trennung ist dabei primär funktionell zu sehen und kann (muss aber nicht) in Form von zwei physisch getrennten Einheiten aufgebaut sein. Das Zielobjekt 27, dessen Distanz 28 zu bestimmen ist, wirft zumindest einen Teil der von der Sendeeinheit 23 emittierten elektromagnetischen Strahlung 24 als Empfangssignal 25 zur Empfangseinheit 22 zurück. In der oberen Hälfte der Figur ist jeweils ein Blockschema eines beispielhaften internen Aufbaus einer Ausführungsform der Sende- 23 bzw. Empfangeinheit 22 dargestellt. Ein Teil der emittierten Strahlung kann dabei auch als Referenzstrahl 26 über einen Referenzpfad bekannter Länge zur Empfangseinheit 22 geführt werden. Dabei kann für den Referenzstrahl 26 und den Messstrahl 25 je eine eigene oder auch eine gemeinsame Empfangseinheit 22 vorgesehen sein. Bei eigenem Referenzempfänger ist die Empfangseinheit 22 oder sind Teile davon (z.B. 10,11,12) entsprechend doppelt auszuführen. Auch eine Umschaltung zwischen Referenz- 26 und Messstrahl 25 ist möglich.

Die Sendeeinheit 22 weist einen Steuerungsprozessor 33 und eine Treiberstufe 5 für die emittierende Komponente 1 auf. Die emittierende Komponente 1 wandelt die elektrischen Signale der Treiberstufe 5 in elektromagnetische Strahlung 24 um (z.B. eine Laserdiode mit stimulierter Emission). Beim Steuerprozessor 33 ist eine PLL 34 dargestellt, welche alternativ auch in der Treiberstufe 5, aber auch extern angeordnet sein kann. Auch können Steuerprozessor 33, Treiberstufe 31 und PLL 34 in einem gemeinsamen Chip integriert sein. Das Versorgungsfilter 36 verbindet die Sendeeinheit 23 mit der Spannungsversorgung 17. Das Versorgungsfilter 36 kann - abhängig von den auftretenden Störungen - von einem einfachen Stützkondensator bis hin zu komplexen LCR-Filternetzwerken ausgeführt sein und gegebenenfalls auch eine Spannungsstabilisierung bzw. -regelung oder einen Hoch- oder Tiefsetzsteller enthalten.

Die Empfangseinheit 22 wandelt empfangene elektromagnetische Strahlung 25 mit dem Empfangselement 10 in ein elektrisches Signal um, welches in der als Block 11 dargestellten Konditioniereinheit für die Weiterverarbeitung aufbereitet wird (beispielsweise verstärkt, gefiltert, heterodyn oder homodyn gemischt, etc.). Die Konditioniereinheit 11 kann also beispielsweise ein Eingangsfilter, ein Verstärker, eine Mischstufe, ein Sample&Hold-Glied, etc. sein, oder auch eine Kombination von diesen. Der Empfänger 10 der optischen Strahlung 25 kann als Empfangselement eine Photodiode verwenden, beispielsweise eine Avalanche-Photodiode mit entsprechender Vorspannung. Das - entsprechend der Modulation des ausgesendeten optischen Signals (und somit auch des empfangenen optischen Signals) - hochfrequente elektrische Ausgangssignal des photosensitiven Elements 10 kann vor der weiteren Verarbeitung und Konditionierung 11 aufbereitet werden, insbesondere impedanzgewandelt, verstärkt und/oder bandbegrenzt (etwa mit einem analogen, aktiven oder passiven Filter, einem Transimpedanzverstärker (TIA), ...). Beispielsweise kann eine solche Verstärkerstufe unter anderem auch mit einer Schaltung nach EP 2 183 865 aufgebaut werden. Alternativ zu einer Transimpedanzwandlung am Ausgang des Empfängers 10 kann auch der Eingang der Konditionierung 11 derart ausgelegt werden, dass diese an die Ausgangscharakteristik des Empfangselements 10 angepasst ist. Ein Beispiel für eine der vielen möglichen Signalfilterungen bei der Konditionierung 11 ist etwa in WO 2011/076907 oder EP-Patentanmeldung Nr. 11187964 gezeigt.

Das konditionierte Empfangssignal wird von einem Analog-Digital-Wandler 12 digitalisiert - also zeit und wert quantifiziert - und einer digitalen Recheneinheit 13 (einem Mikroprozessor, DSP, FPGA, ASIC, etc.) zur Weiterverarbeitung und Bestimmung der Distanz zugeführt. Weiters ist eine PLL 14 mit einem Oszillator 15, beispielsweise einem Schwingquarz, verbunden. Wie in elektronischen Schaltung üblich, ist auch hier eine (wie zuvor bereits erwähnte) Filterung 16 der Spannungsversorgung 17 dargestellt, welche nicht nur global für die gesamte Schaltung, sondern auch dezidiert bei einzelnen Komponenten der Schaltung platziert sein kann.

Die in **Fig. 1** gezeigte Aufteilung des EDM-Systems 1 kann insbesondere auch zur Vermeidung bzw. Reduktion eines Übersprechens der elektrischen Signale genutzt werden, was zu einer erhöhten Signalqualität und somit zu einer genaueren oder schnelleren Messung beiträgt. Dabei kann eine verbesserte Unterdrückung von Übersprech-Effekten erzielt werden, indem eine örtliche Trennung von Signalen, welche zur Signalauswertung asynchron bzw. nicht in Phase liegend sind, vorgenommen wird. Im Speziellen bei direkt abtastenden Systemen kann somit beispielsweise ein strikt synchrones Empfängerdesign erreicht werden. Beispielsweise bei homodyner Mischung sind die dabei auftretenden asynchronen Signale auch vielfach Verursacher von Störungen in den Messsignalen.

In EDM-Designs ist vielfach der Sender 23, speziell der Laserdioden-Treiber 5, eine der primären Störquellen. Um die messprinzipbedingt geforderten kurzen optischen Pulse hoher Intensität zu generieren, sind in der Ansteuerung kurze Stromimpulse mit hohen Spitzenwerten, steilen Flanken und entsprechend breitrandigem Frequenzspektrum nötig. Zudem sind die Modulations- bzw. Emissionsfrequenz auf Grund des Auswerteprinzips meist auch im selben Größenordnungsbereich wie die Auswertefrequenz, was eine einfache Ausfilterung des störenden Frequenzbereichs erschwert oder verunmöglicht.

Um auch die Sendeschaltung zum Empfänger zu synchronisieren, kann ein Taktsignalausgang der PLL 14 (oder DLL 14) auch vom Empfänger 2 zum Sender 3 geführt werden. Speziell kann durch eine Übertragung eines von der Empfänger-PLL 14 synchronisierten Taktsignals 37 (anstelle des asynchronen Oszillatorsignals) eine hohe Synchronisationsgenauigkeit erzielt werden, welche auch einen Oszilator-PLL-Jitter ausschließt. Da die Sendeeinheit 3 ebenfalls über eine PLL 34 verfügt, ist es hinreichend zur Synchronisation ein (relativ zu den hohen Auswertetaktraten) relativ niederfrequentes Signal 37 zu übertragen, was sowohl Vorteile in Bezug auf die Störabstrahlung als auch auf die zur Übertragung benötigte Leistung und Treiberstufen auswirkt. Durch die Signalrichtung vom Empfänger 2 zum Sender 3 kann (speziell auch aufgrund der Impedanzverhältnisse von Signalausgang zu Signaleingang) ein Übersprechen in die Gegenrichtung gering gehalten werden.

Neben der Synchronisation des Senders 3 gegenüber dem Empfänger 2 können diese beiden Schaltungsteile über eine Kommunikationsverbindung 38 zur Steuerung der zur Messung erforderlichen Abläufe verfügen. Zur Vermeidung von Übersprechen kann eine derartige Kommunikation ebenfalls in dieselbe Richtung wie das Taktsignal 37 - also unidirektional vom störempfindlichen Empfänger 2 hin zum meist störungsverursachenden Sender 3 - erfolgen. Die Kommunikation 37 kann dabei ebenfalls synchron zum übertragenen Taktsignal 38 erfolgen, beispielsweise als unidirektionale, synchrone serielle Schnittstelle, wodurch zusätzlich kommunikationsbedingte Störungen vermieden werden können.

Die Trennung von Sender 3 und Empfänger 2 erlaubt es auch, jedem der beiden getrennten Schaltungsteile einen speziell abgestimmten Versorgungsfilter 16,36 zukommen zu lassen, wodurch auch ein Übersprechen über die Spannungsversorgung 17 verhindert oder zumindest reduziert werden kann. Weiters können zwischen Sender 3 und Empfänger 2 auch entsprechende EMI-Barrieren 9 (z.B: in Form von EMI-Störableitern, Guardbanding-Layouts, Schirmungen, Metallkäfigen, abschirmenden Metallfolien oder Blechen, etc.) angebracht werden.

Die Trennung von Sender 3 und Empfänger 2 kann dabei örtlich, etwa durch die Verwendung von jeweils dezidierten Chips (FPGAs, ASICs, ...) erfolgen. Diese können bei entsprechender layouttechnisch getrennter Gestaltung durchaus physikalisch auf einer gemeinsamen Leiterplatte untergebracht sein. Ein Aufbau des EDM-Systems 1 mit zwei getrennten Leiterplatten (wobei mit Leiterplatten auch Trägersubstrate von Schaltkreisen in Dickschicht- oder Dünnschichttechnik gemeint sein können) erlaubt gegebenenfalls mehr Flexibilität im Gerätedesign (z.B. auch zur optischen Justage der Emissionsrichtung des Emitters 30 des Senders 3 gegenüber dem Empfangselement 10 des Empfängers 20 - oder umgekehrt, sowie der Komponentenanordnung innerhalb des Geräts 1). Durch die Trennung und ein entsprechendes Gerätedesign kann eine höhere Übersprech-Unterdrückung erzielt werden.

Eine Treiberstufe 5 - sozusagen das Herzstück der Sendeeinheit 23 - lässt sich, neben einem Aufbau aus mehreren diskreten Komponenten, auch mittels Standard-Halbleiterprozessen komplett oder zumindest zu einem großen Teil in ein Halbleiterbauelement integrieren, z.B. in einen ASIC. Neben der Ansteuersignalgenerierung sowie gegebenenfalls auch der Endstufe (oder zumindest Teile davon) können in Folge auch weitere Systemkomponenten wie z.B. die PLL 34, die Ansteuerlogik 33 bzw. der Prozessor 33 in Form eines Digitalrechners, Speicherzellen, etc. alle in einem gemeinsamen Sender-Chip integriert werden. Dieser bedarf zum Betrieb nur noch eine minimale Anzahl an externen Komponenten, eine sogenannte 1-Chip-Lösung. Eine Ausführungsform eines erfindungsgemäßen EDMs lässt sich somit beispielsweise durch zwei Chips, für die Sendeeinheit 23 und die Empfangseinheit 22 realisieren, welche abgesehen von den photoaktiven Elementen und diversen nicht integrierbaren Komponenten kaum externe Bauteile benötigen. Gegebenenfalls kann das System noch um einen externen Prozessor, Mikrocontroller oder DSP ergänzt werden, welcher speziell Auswerte- oder Interfacing-Aufgaben übernehmen kann. Diese können wie beschrieben auf einer gemeinsamen oder zwei getrennten Leiterplatten 4 untergebracht sein, welche dann elektrisch (und gegebenenfalls auch mechanisch) miteinander verbunden werden.

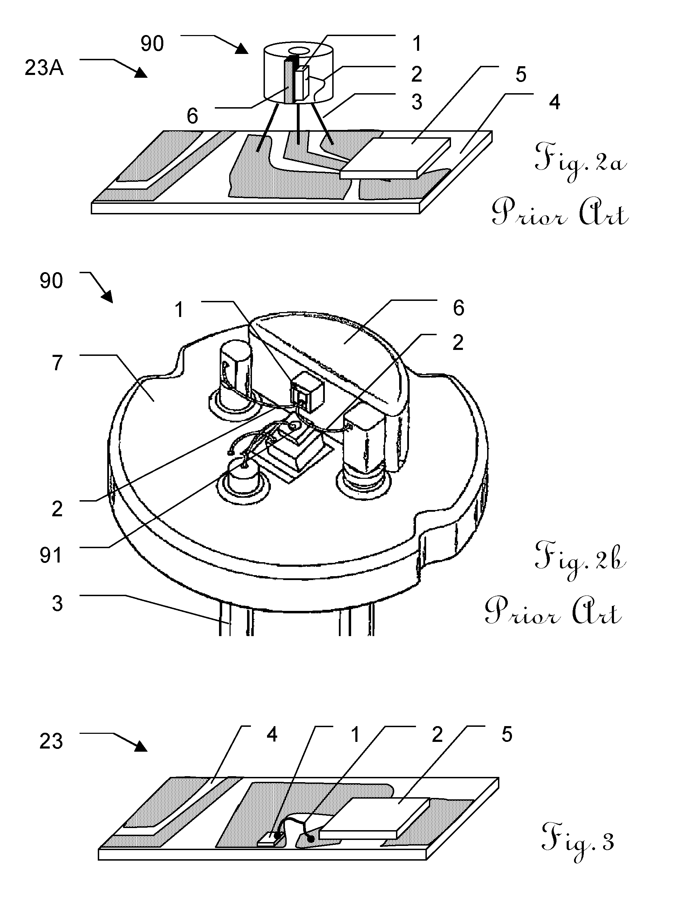

**Fig. 2a** stellt eine Ausführung einer Sendeeinheit 23A eines EDMs dar, also jenes Teils der Elektronikschaltung, welcher die Generierung und Aussendung von optischen Pulsen zur Aufgabe hat, wie diese im Stand der Technik gebräuchlich sind. Diese Sendeeinheit muss nicht zwingend als getrennte Einheit aufgebaut sein, sondern kann auch gemeinsam mit weiteren Schaltungseinheiten auf einer Leiterplatte 4 untergebracht sein. Es kann sich also auch um eine logische Einheit handeln. Auch kann diese Sendeeinheit 23 durchaus in ihrer geometrischen Anordnung verteilt sein, beispielsweise können die Laserdiode 90 und die zugehörige Treiberschaltung 5 jeweils separat am Gehäuse oder an separaten Gehäuseteilen befestigt und nur mit elektrischen Leitern 3 untereinander verbunden sein, beispielsweise um eine Justage zur Kollimierung des ausgesendeten Lichtstrahls bei der Produktion des EDMs zu ermöglichen.

Die bekannten Laserdioden-Bauelemente 90 haben dabei ein Gehäuse 7, in welchem sich eine Halterung 6 für das eigentliche lichtemittierende Halbleitersubstrat 1, also den eigentlichen Laserresonator, befindet. Die äußeren elektrischen Anschlüsse 3 der Laserdiode 90 sind intern über Bonddrähte 2 mit dem Halbleitersubstrat verbunden.

**Fig. 2b** zeigt eine bekannte Ausführungsform eines Laserdioden-Bauelements 90 aus dem Stand der Technik ohne den oberen Teil des Gehäuses 7 in einer Nahaufnahme. Darin ist wiederum der eigentliche Halbleiterlaser 1, welcher auf den Träger 6 montiert ist, dargestellt. Im gezeigten Beispiel befindet sich zwischen dem Lasersubstrat 1 und dem Träger 6 noch am Zwischenteil, welches das Lasersubstrat 1 von hinten kontaktiert und über einen Bonddraht 2 mit einem Anschluss 3 verbindet, aber diesen Kontakt elektrisch vom Träger 6 bzw. vom Gehäuse 7 isoliert. Die vordere Seite des Lasersubstrats 1 ist direkt mit einem Bonddraht 2 kontaktiert, welcher zu einem zweiten Anschluss 3 führt. Weiters ist eine Monitor-Photodiode 91 gezeigt, welche zur Ausgangsleistungsregelung des Lasertreibers 5 verwendet werden kann, insbesondere um eine Einhaltung der Lasersicherheitsrichtlinien gewährleisten zu können oder auch das temperaturabhängige Emissions verhalten des Halbleiterlasers kompensieren zu können. Zu diesem Zwecke wird ein Teil des emittierten Laserlichts auf diese Monitordiode ausgekoppelt; vielfach geschieht dies über eine geringe Auskopplung am nach innen gerichteten Ende des Resonators.

In **Fig. 3** wird schematisch eine Ausführungsform einer erfindungsgemäßen Sendeeinheit 23 eines EDMs 99 gezeigt, bei welcher der lichtemittierende Halbleiter 1 ohne Gehäuse 7 auf der Leiterplatte 4 aufgebracht ist. Der Lasertreiber 5 ist dabei, beispielsweise über einen Bonddraht 2, mit dem Halbleiter 1 verbunden. Neben dem Wire-Bonding sind in diesem Technologiefeld auch andere Methoden wie etwa Friction-Bonding bekannt, welche ebenfalls erfindungsgemäß eingesetzt werden können, beispielsweise zur Aufbringung des Halbleitersubstrats 1 auf die Leiterplatte 4. Erfindungsgemäß wird durch einen derartigen Aufbau eine Verbesserung eines EDMs, speziell einer Sendeeinheit 23 eines EDMs, erzielt. Speziell kann durch die erfindungsgemäße Anordnung die Zuleitungsinduktivität zum Halbleiterlaser 1 verringert werden. Dieses bringt Vorteile für eine Emission von hochfrequenten Laserpulsen, da bei einer geringen Induktivität das Einprägen von kurzen und hohen Stromimpulsen einfacher realisierbar ist, wodurch beispielsweise der Lasertreiber 5 einfacher gestaltet werden kann. Wird hier von einem Bonddraht 2 gesprochen, so umfasst dieses auch mehrere parallele Bonddrähte 2, um beispielsweise einen größeren Zuleitungsquerschnitt und damit auch eine geringere Zuleitungs impedanz zu erzielen oder um eine gleichmäßige Stromverteilung durch mehrfache Kontaktierung des Halbleiters 1 zu erreichen.

Auch kann mithilfe des erfindungsgemäßen Konzepts eine kompaktere Bauform erreicht werden. Dieses kann nicht nur eine Miniaturisierung der Baugröße des EDMs dienlich sein. Das erfindungsgemäße Konzept kann auch zu einer vorteilhaften Reduzierung der elektromagnetischen Störaussendung der schnellen Puls- oder Burstmodulation in einem EDM genutzt werden, indem ein elektromagnetisches Übersprechen vom Sender- zum Empfängerteil verringert werden kann. Die kurzen elektrischen Pulse mit steilen Signalflanken strahlen durch eine erfindungsgemäße Kontaktierung zwischen Lasertreiber 5 und Halbleiterlasersubstrat 1 auch entsprechend weniger elektromagnetische Wellen ab, nicht zuletzt durch die erfindungsgemäß verkürzten Signalwege, welche als Antennen wirken.

Das erfindungsgemäße Prinzip eignet sich insbesondere bei einem EDM, welcher mit einem monitordiodenlosen Lasertreiber ausgestattet ist, beispielsweise wie dieser in der oben angeführten Referenz beschrieben ist. Es kann jedoch auch in der erfindungsgemäßen Ausführungsform eine Monitor-Photodiode auf die Leiterplatte bestückt werden, auf welche ein Teil der emittierten Laserstrahlung ausgekoppelt wird und welche zur Überwachung der emittierten Ausgangsleistung genutzt werden kann. Alternativ kann in einem EDM mit interner Referenzstrecke auch eine Photodiode zum Empfang dieses Referenzlichts herangezogen werden, um die Ausgangsleistung zu Überwachen, da ja der über den Referenzpfand ausgekoppelte Lichtanteil bekannt und über die Gerätelebensdauer konstant ist. Somit lässt sich ein Empfänger für einen über einen geräteinternen Referenzpfand geleiteten Lichtanteil als Monitordiode zur Überwachung der Lasersicherheit nutzen. Dies kann auch als eigenständige Erfindung angesehen werden, welche auch unabhängig von der erfindungsgemäßen Halbleiteranordnung angewandt werden kann, also beispielsweise auch in Zusammenhang mit Laserdioden, Laserdiodenaufbringungen und Treiberschaltungen aus dem Stand der Technik. Insbesondere kann dieses auch als Weiterbildung des weiter oben referenzierten monitordiodenlosen Lasertreibers gesehen werden, beispielsweise als zusätzliche Überwachungsinstanz, etwa auch um eine höhere Sicherheitsklasse erreichen zu können.

Das in **Fig. 3** schematisch dargestellte Ausführungsbeispiel dient zur Erläuterung des grundsätzlichen, erfindungsgemäßen Aufbauprinzips und der Funktionsweise einer erfindungsgemäßen EDM-Sendeeinheit. Einige der erfindungsgemäß umfassten, speziellen Ausführungsformen werden anhand der folgenden Figuren im Detail weiter ausgeführt, wobei die dabei gezeigten Ausgestaltungen nicht als abschließende Aufzählung zu betrachten sind.

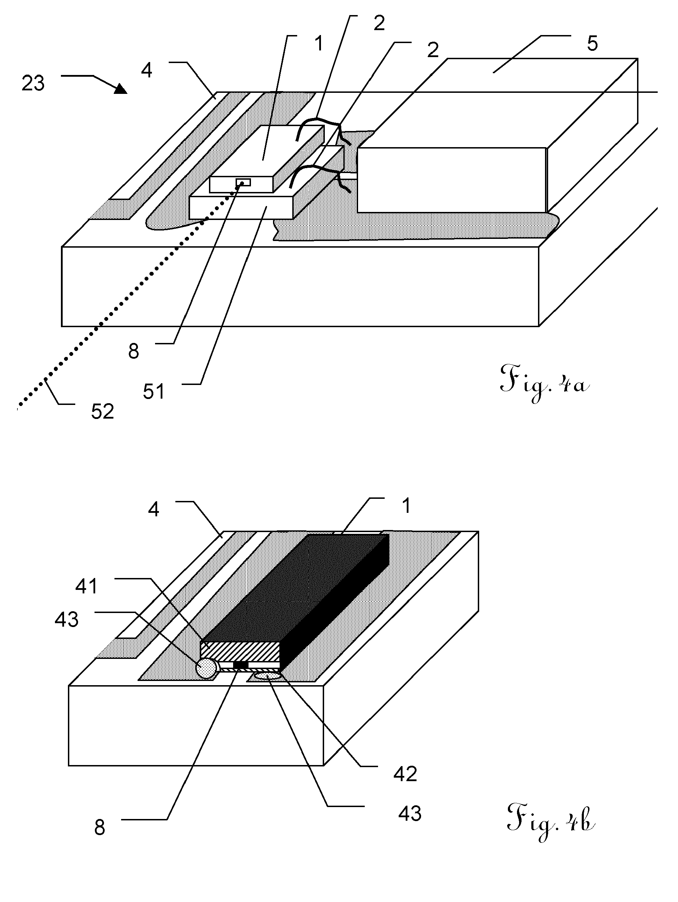

In **Fig. 4a** ist eine beispielhafte Ausführungsform eines erfindungsgemäßen Aufbaus einer EDM-Sendeeinheit dargestellt. Die Leiterplatte 4 im Sinne der vorliegenden Erfindung kann beispielsweise eine FR1 bis FR4, CEM1, CEM3, Teflon-, Silizium- oder Keramik- Printplatte mit Einlagen-, Mehrlagen- oder HDI-Aufbau sein. Anders ausgedrückt ist unter Leiterplatte 4 allgemein ein nicht leitendes Trägermaterial mit Strukturen aus elektrisch leitfähigen Leiterbahnen zur Verbindung von elektronischen Bauteilen und Herstellung von elektrischen Netzen sowie zur mechanischen Fixierung von Bauteilen zu verstehen.

Erfindungsgemäß ist auf dieser Leiterplatte 4 ein Halbleiterlaser-Substrat 1 und ein Lasertreiber 5 bzw. zumindest die Leistungsstufe des Lasertreibers 5 (z.B. der leistungsschaltende Transistor des Lasertreibers 5) aufgebracht. Der Halbleiterlaser 1 ist dabei als gehäuseloses Lasersubstrat oder Laser-Die aufgebracht, also lediglich als das die Halbleiter-Laserstruktur bildende Halbleitersubstrat, welches zur Bildung eines Laserresonators entsprechend an beiden Enden verspiegelt ist und auf einer Seite ein Austrittsfenster 8 für die stimulierte Emission von Laserlicht 52 aufweist. Der Halbleiterlaser 1 ist als sogenannte kantenemittierende Laserdiode ausgeführt. Diese kann als kubusförmiges Halbleitersubstrat ausgeführt sein, mit P- und N-Dotierten Halbleiterschichten, zwischen welchen in einer sogenannten Spaltebene der Lichtverstärkungsvorgang stattfindet. Die stimulierte Emission von Licht findet dabei an den Seitenflächen (meist der kleinsten Seitenfläche des Kubus - daher der Begriff "kanten-emittierend") statt, welche als optische Spiegel ausgebildet sind und den Laserresonator bilden, von welchem auf zumindest einer Seite der Laserstrahl ausgekoppelt wird. Aufgrund des schichtweisen P-N-Aufbaus erfolgt die Kontaktierung der Halbleitermaterialien (in der Standard- oder Basisvariante, also ohne weitere konstruktive Maßnahmen) von gegenüberliegenden Seiten bzw. Flächen.

Erfindungsgemäß wird also das im Stand der Technik vorhandene Gehäuse 7 weggelassen. In der hier dargestellten ersten Ausführungsform wird dabei der Halbleiterlaser 1 über ein elektrisch isolierendes Zwischenelement 51 auf die Leiterplatte 4 aufgebracht. Dem Zwischenelement 51 kommt in dieser Ausführungsform eine elektrische Kontaktierung der Unterseite des Halbleiterlasers 1, eine Wärmeabfuhr hin zur Leiterplatte 4, sowie ein Erhöhung des Halbleiterlasers 1 zu, damit es aufgrund der Strahldivergenz des emittierten Laserlichts 52 (von typisch ca. 5 bis 30°, je nach Ausführung und Divergenzachse) nicht zu einer teilweisen Abschattung des Lichtstrahls durch die Leiterplatte 4 kommt. Da insbesondere die Ränder von Leiterplatten recht hohen Maßtolleranzen unterworfen sind, kann eine derart erhöhte Positionierung vorteilhaft sein, speziell im Vergleich zu den Positioniergenauigkeiten der Bauelemente auf der Leiterplatte 1, welche beispielsweise in einer Größenordnung von etwa 30 µm liegen und meist deutlich genauer als die oft geritzten, gestanzten oder grob gefrästen Leiterplattenränder ist.

Um erfindungsgemäß die Zuleitungsinduktivität zum Halbleiterlaser 1 gering zu halten, ist dieser auf kurzem Wege mittels Bonddrähten 2 auf die Leiterbahnen der Printplatte 4 kontaktiert. Fertigungstechnisch spricht man hierbei von einer Chip-On-Board-Technologie (COB), im deutschsprachigen Raum auch als "Nacktchipmontage" bezeichnet. Die gezeigte Ausführungsform kontaktiert dabei die Oberseite des Halbleiters 1 direkt mit einem Bonddraht 2; die Unterseite ist mittels einer leitfähigen Schicht auf dem Zwischenelement 51 - auf welcher der Halbleiters 1 mit seiner unteren Kontaktfläche leitfähig montiert ist - ebenfalls mit einem Bonddraht auf die Leiterplatte 4 verbunden. Auf der Leiterplatte 4 befindet sich auch der Lasertreiber 5, welcher hier als ein monolithes Bauteil dargestellt ist, aber auch wie beschreiben aus mehreren diskreten und/oder integrierten Bauelementen aufgebaut sein kann. Um die erfindungsgemäß erzielte niedrige Anschlussinduktivität nicht zu verwirken, sollte dabei zumindest die Leistungsstufe oder Endstufe des Lasertreibers 5, welche sich auch auf derselben Leiterplatte 4 wie der Halbleiterlaser 1 befindet, mit kurzen Leitungslängen angebunden werden. Alternativ kann das Zwischenelement 51 auch leitfähig sein, wodurch die Unterseite des Halbleiterlasers 1 mittels dessen auf die Leiterplatte 4 kontaktiert werden kann. Wird der Lasertreiber 5 bzw. dessen Endstufe ebenfalls in Nacktchipmontage ausgeführt, kann auch eine direkte Bonddraht-Verbindung zwischen dem lichtemittierenden und dem ansteuernden Halbleiter hergestellt werden.

Durch die erfindungsgemäße Montage auf der Leiterplatte 4 kann auch eine gute Wärmeabfuhr vom Halbleiter 1 erzielt werden. Speziell bei einer Montage auf einer entsprechend großflächigen und dicken, äußeren Kupferlage kann eine gute Wärmeabfuhr erzielt werden, welche beispielsweise durch ein zusätzliches Aufbringen von Kühlkörpern (z.B. durch auflöten auf die Kupferfläche), mehrfaches Durchkontaktieren auf weitere Leiterplattenlagen (z.B. einer unterseitigen, flächigen Groundplane) etc. noch verbessert werden kann. Beispielsweise kann auch ein zur Reduktion der ausgesendeten elektromagnetischen Störungen aufgelötetes Abschirmblech oder Abschirmgehäuse als Kühlkörper fungieren.

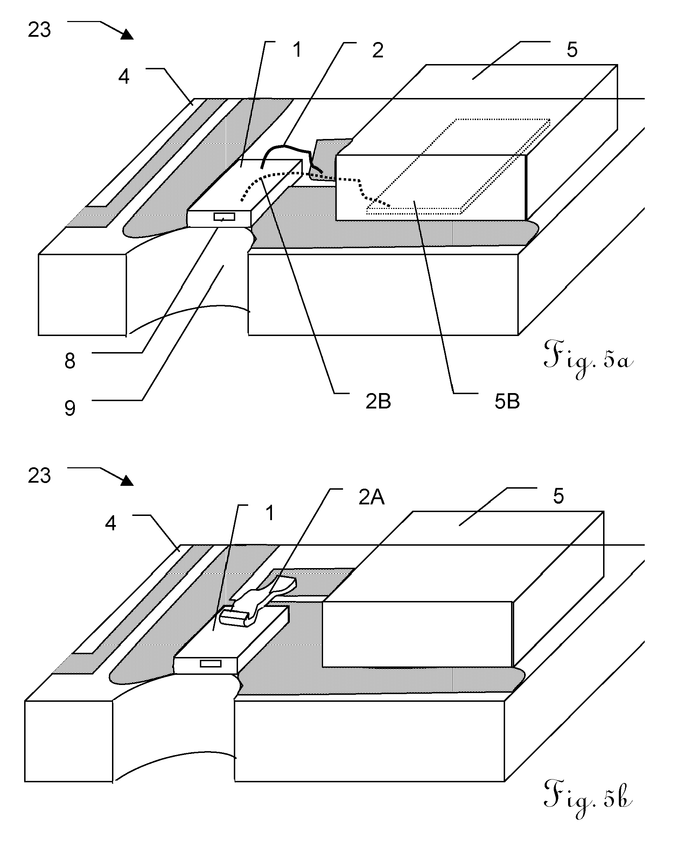

Dabei wird anhand von **Fig. 5a** eine zweite beispielhafte Ausführungsform des erfindungsgemäßen Prinzips dargestellt. Darin ist der Halbleiterlaser 1 direkt auf der Leiterplatte 4 angebracht, beispielsweise verlötet oder mittels leitfähigem Kunststoff bzw. Kleber mechanisch und elektrisch mit einer ersten Leiterbahn der Leiterplatte 1 verbunden. Der zweite, obere Anschluss des Halbleiters ist dabei mit einem Bonddraht 2 auf eine zweite Leiterbahn der Leiterplatte 4 verbunden. Die punktiert dargestellte Bond-Verbindung 2B vom Lasersubstrat 1 zur Endstufen-Halbleiter 5B des Lasertreibers 5 ist eine weitere alternative, erfindungsgemäße Ausführungsform. Derartige COB-Bond-Verbindungen werden zum Schutz vor mechanischer und/oder chemischer Beschädigung vielfach vergossen, z.B. mit Epoxidharz oder ähnlichem.

Alternativ kann wie in **Fig. 5b** dargestellt die Oberseite des Halbleiters 1 beispielsweise auch mit einem Kontaktstreifen kontaktiert werden, welcher auf der Leiterplatte 1 befestigt ist und z.B. Federn von oben auf den Halbleiter 1 drückt und/oder auf der Oberseite des Halbleiters 1 z.B. ebenfalls durch Kleben oder Löten kontaktiert wird. Dabei können auch mechanische Führungen ausgestaltet werden, welche eine exakte Postionisierung des Halbleiters 1 sicherstellen.

Sowohl die Variante aus **Fig. 5a** wie auch **Fig. 5b** sind erfindungsgemäße Ausführungsformen einer direkten Montage des Halbleiterelements 1. Um die Zuleitungsinduktivität zum Halbleiterlaser 1 gering zu halten, ist dieser mit einer Kontaktflächen direkt mit der Leiterplatte verbunden und die andere Kontaktfläche z.B. mittels Bonddrähten 2 bzw. Kontaktstreifen 2A direkt auf die Leiterbahnen der Leiterplatte 4 kontaktiert.

Im Rahmen der in der Chip-On-Board-Technologie gebräuchlichen Begriffe können hierbei verschiedene Varianten unterschieden werden. Beispielsweise kann die sogenannte Chip&Wire-Variante angewandt werden, bei welcher der Halbleiter von oben (also von der Leiterplattenabgewandten Seite) kontaktiert wird, wie dieses **Fig. 4a** darstellt.

Alternativ existiert auch die sogenannte Flip-Chip-Technik, bei welcher die Kontakte des Halbleiters 1 der Leiterplatte 4 zugewandt sind und beispielsweise über Lötkugeln oder leitfähigen Kunststoff elektrisch und mechanisch verbunden werden. Da die Standard-Halbleiterlaser (unter anderem bedingt durch den schichtweisen Aufbau ihrer Halbleiterstrukturen) meist auf gegenüberliegenden Flächen (z.B. von oben und von unten) kontaktiert werden müssen, sind diese per se einer Flip-Chip-Montage leider nicht zugänglich, sodass wie beschrieben zumindest ein einziger Bonddraht 2 oder Kontaktstreifen 2A erforderlich ist. Dieses kann durch entsprechendes Design der Halbleiterstrukturen zur Verlegung beider Anschlüsse auf eine Seite durchaus behoben werden. Die zu produzierende Stückzahl, ab welcher sich eine derartige Modifikation lohnt, ist im allgemeinen jedoch recht hoch, speziell im Vergleich zu den Standardkomponenten.

Um eine Flip-Chip-Montage zu ermöglichen, kann als eine weitere erfindungsgemäße Ausführungsform bei einem Standard-Halbleiterlasersubstrat an einer Stelle oder auf einer Seite die untere Halbleiterschicht 42 entfernt, z.B. weggeätzt oder mechanisch abgetragen werden, sodass dort die gegenüberliegende, obere Halbleiterschicht 41 z.B. mit einem Ball 43 oder ähnlichem ebenfalls von unten kontaktiert werden kann. Die freigelegte untere Halbleiterschicht kann beispielsweise auch mit einem zweiten Bonddraht 2 kontaktiert werden, sodass neben der zuvor genannten Kontaktierung über Anschlüsse nach unten zur Leiterplatte 4 oder dem Lasertreiber 5 auch eine Montage mit den Anschlüssen nach oben und einem Bonding dieser Anschlüsse zur Leiterplatte 4 oder dem Lasertreiber 5 ausgeführt werden kann. Dabei kann eine elektrisch leitfähige Kontaktierung der Unterseite des Halbleiterlasers 1 entfallen, was weitere Montagemöglichkeiten eröffnet.

Eine beispielhafte Ausführungsform einer Flip-Chip-Montage ist in **Fig. 4b** dargestellt. Da die zu entfernende Halbleiterschicht 42 meist recht dünn ist (z.B. im Bereich von ca. 3-5 µm), lässt sich eine derartige Modifikation recht einfach an bereits gefertigten Standardhalbleitern 1 vornehmen. Die Flip-Chip-Montage kann dabei direkt auf die Leiterplatte 4 oder auch huckepack auf den Lasertreiber-Chip 5 erfolgen. Dabei kann die Huckepack-Montage im Halbleiterwerk als Baugruppe vorgefertigt werden, welche dann als COB auf die Leiterplatte 4 bestückt werden kann und z.B. mit Bonddrähten an die Printplatte angeschlossen werden kann. Ein Verguss der Baugruppe in ein Gehäuse (z.B. mit Beinchen- oder Ball-Anschluss) kann ebenfalls durchgeführt werden, sofern ein Fenster für den Lichtaustritt vorgesehen wird. Mit einer der oben beschriebenen, direkten elektrischen Anbindung des Halbleiterlasers kann eine sehr geringe Anschlussimpedanz erzielt werden. Aufgrund des geringen Abstandes des Lichtaustrittfensters 8 zur Montagefläche muss gegebenenfalls eine mögliche, teilweise Abschattung des divergenten Lichtstrahls bei der Wahl der Montageposition bedacht werden, beispielsweise durch eine gegenüber dem darunter liegenden Bauteil vorstehendes Emissionsfenster oder andere konstruktive Maßnahmen.

Um eine Abschattung durch die Leiterplatte 4 zu vermeiden ohne dabei hohe Maßtoleranzen des Leiterplattenrandes zu fordern, ist der lichtemittierende Halbleiter 1 an einem bei der Leiterplattenherstellung gebohrten Lochs 9 - oder genauer gesagt am Umfang eines Teils eines Lochs 9 - platziert. Diese Löcher 9 sind im Standard-Prozess der Leiterplattenherstellung mit hohen Maßtoleranzen herstellbar und bedürfen daher keiner kostspieligen, zusätzlichen Fertigungsschritte. Die Toleranzen der Leiterplattenränder können daher grob gehalten werden, da bei der Herstellung des Randes lediglich eine Zerteilen - also beispielsweise ein in etwa Halbieren - des Loches erreicht werden muss. Dies kann z.B. schon bei einem Lochdurchmesser in der Größenordnung von mehr als dem Doppelten der Maßtoleranz des Randes (beispielsweise dem Drei- oder Vierfachen oder auch mehr) erreicht werden. Da die Bauteilplatzierung bei der Leiterplattenbestückung ohnehin relativ zu den Löchern erfolgt (bzw. erfolgen muss), kann eine Positionsgenauigkeit des Halbleiterlasers 1 bezüglich des Loches 9 von weniger als 100 µm problemlos erreicht werden, meist sogar darunter, etwa bei 30 µm oder weniger. Ein weiterer Vorteil der in dieser Ausführungsform gezeigten, erfindungsgemäßen Aufbringung am Rande eines solchen Loches 9 ist auch, dass die Lichtquelle nicht exponiert, sondern gegenüber dem Rand zurückgesetzt aufgebracht werden kann, was auch vor mechanischen Beschädigungen schützt, insbesondere während der Fertigung und Assemblierung des EDMs.

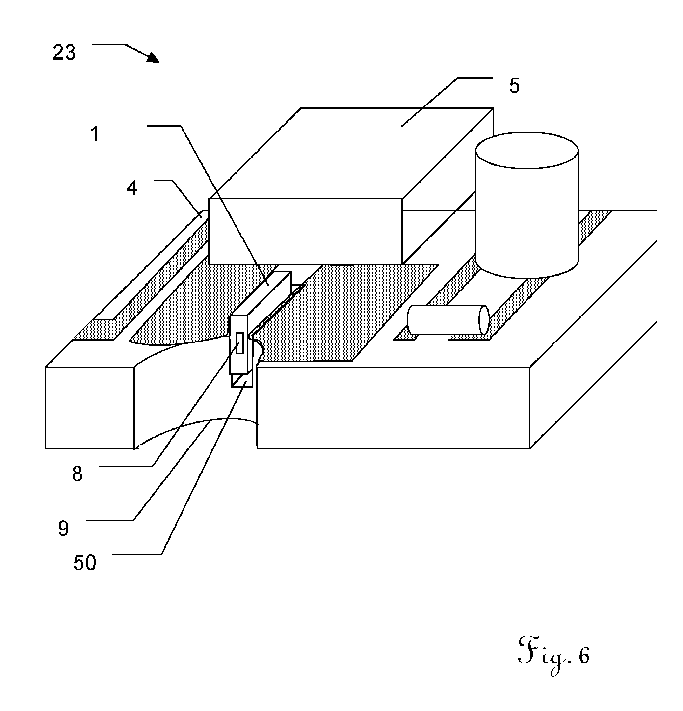

**Fig. 6** illustriert eine Ausführungsform, in welcher die erwähnte, vielfach gebräuchliche Anschlussbelegung auf gegenüberliegenden Flächen des Halbleitersubstrates und die dadurch notwendige Kontaktierung von zwei Seiten durch eine hochkantige Montage gelöst wird. In der gezeigten beispielhaften Ausführungsform wird dabei der Halbleiter in einen Schlitz 50 in die Leiterplattenoberfläche eingebracht und seitlich (bzw. aus Sicht des nun um 90° rotierten Halbleiters von oben und unten) von jeweils einer Leiterbahn kontaktiert, beispielsweise durch Löten oder konduktives Kleben. Der Schlitz 50 kann dabei eine bezüglich der Leiterplattendicke durchgängige oder nicht durchgängige Einkerbung sein, z.B. hergestellt durch Fräsen, Bohren einer überlappenden Lochreihe, Sägen, Laserschneiden, Lasergravieren, etc.. Ein derartiges aufrechtes Aufbringen des Halbleiters 1 ist grundsätzlich auch ohne eine derartige Einkerbung 50 direkt auf die Leiterplattenoberfläche möglich, kann sich aber in Standard-Fertigungsprozessen schwierig gestalten. Die Einkerbung 50 kann auch als Spalt oder Abstand zwischen zwei Leiterbahnen der Leiterplatte realisiert werden, welcher das Halbleitersubstrat aufnehmen kann. Insbesondere bei entsprechend hoher Schichtdicke des Leiterbahnmaterials der obersten Lage (von z.B. 70 oder 100 µm) kann der Halbleiter 1 hochkant in den Zwischenraum eingebracht und jeweils seitlich von den Leiterbahnen kontaktiert werden.

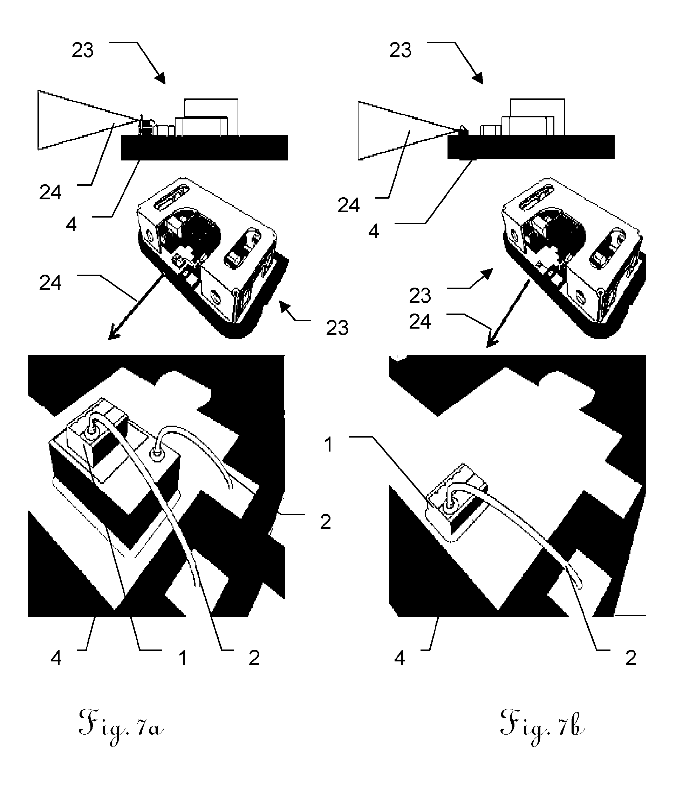

**Fig. 7a** und **Fig. 7b** zeigen zwei weitere konkrete Ausführungsformen einer erfindungsgemäßen Sendeeinheit 23 eines EDMs, jeweils in einer Seitenansicht, einer axonometrischen Darstellung der gesamten Sendeeinheit 23, sowie einer Detailansicht der erfindungsgemäßen Aufbringung des optischen Sendeelements 1. Die Aufbringung des Halbleiters 1 kann dabei mittels leitfähigem Epoxy erfolgen, und die obere P-Seite des Halbleiters 1 kann mit einem Bonddraht 2 auf die Leiterplatte 4 kontaktiert sei. In **Fig. 7a** ist zusätzlich ein Zwischenelement 51 dargestellt.

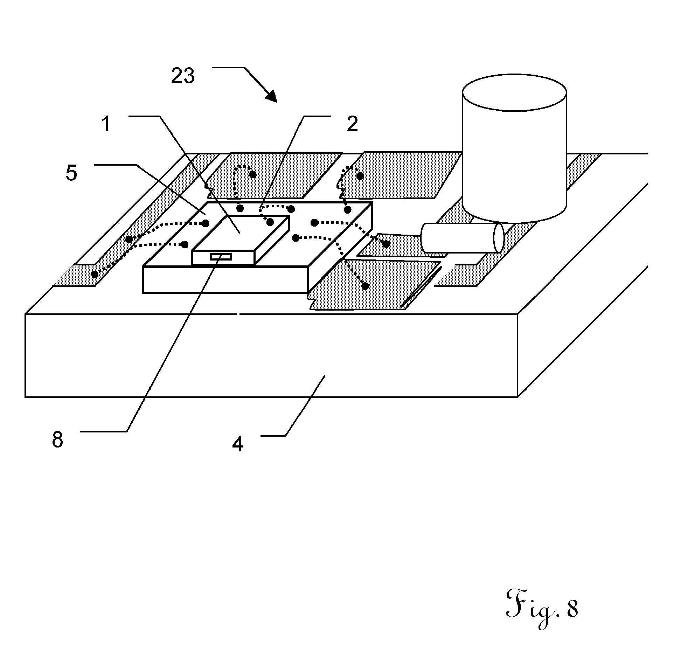

**Fig. 8** zeigt eine Ausführungsform, welche eine Chip-On-Chip-Montage des Halbleiterlasers 1 auf dem Lasertreiber 5 (bzw. dessen Endstufe) zeigt. Dabei ist der Lasertreiber 5 als Nacktchip auf die Leiterplatte 4 bestückt und mit Bonddrähten 2 mit dieser elektrisch verbunden. Auf der dem Lasertreiber 5 zugewandten Seite ist der Laserhalbleiter 1 direkt konduktiv mit dem Lasertreiber 5 verbunden, und der zweite elektrische Anschluss wird von oben mit einem Bonddraht 2 vom Laser 1 zum Treiber 5 hergestellt. Alternativ kann auch eine oben beschrieben Flip-Chip-Montage des Laserhalbleiters 1 angewandt werden, insbesondere können dabei die beiden Halbleiter bereits als vorgefertigte gemeinsame Baugruppe auf die Leiterplatte 4 bestückt werden.

In für den Fachmann offensichtlicher Weise können auch weitere Ausführungsformen mit einem erfindungsgemäßen Aufbau der Sendeinheit 23 realisiert werden, welche ingenieursmäßig entsprechend der Bedürfnisse des konkreten Distanzmessers adaptiert bzw. optimiert werden können.

## Patentansprüche

1. Optoelektronischer Entfernungsmesser (99), insbesondere Laser-Distanzmesser, mit:
■ einer Sendeeinheit (23) mit einer Leiterplatte (4), einem Halbleiterlaser (1) und einem Lasendiodentreiber (5), zur Aussendung von hochfrequent intensitätsmodulierter optischer Strahlung (24),
■ einer Empfangseinheit (22) zum Empfang eines von einem Zielobjekt (27) zurückgeworfenen Anteils (25) der optischen Strahlung (24) durch ein photosensitives elektrisches Bauelement (10) mit einem elektrischen Ausgangssignal als Empfangssignal, insbesondere mit einer Photodiode,
■ einer Konditioniereinheit (11) zur Konditionierung des Empfangssignals,
■ einem Analog-Digital-Wandler (12) zur Digitalisierung des konditionierten Empfangssignals und
■ einer elektronischen Auswerteeinheit (13), welche auf Basis einer Signallaufzeit anhand des digitalisierten Empfangssignals eine Distanz (28) vom Entfernungsmesser (99) zum Zielobjekt (27) ermittelt,
**dadurch gekennzeichnet, dass**
der Halbleiterlaser (1) als gehäuseloses Lasersubstrat, insbesondere elektrisch leitend, auf die Leiterplatte (4) aufgebracht ist,
insbesondere wobei das Lasersubstrat (1) mit einem Bonddraht (2) elektrisch mit der Leiterplatte (4) oder dem Laserdiodentreiber (5) verbunden ist.

2. Entfernungsmesser (99) nach Anspruch 1, **dadurch gekennzeichnet, dass**
das Lasersubstrat (1) am Rande eines durch einen Leiterplattenrand geteilten Loches (9) platziert ist.

3. Entfernungsmesser (99) nach einem der Ansprüche 1 oder 2, **dadurch gekennzeichnet, dass**
beim Lasersubstrat (1) eine erste Halbleiterschicht (41) als erster Anschluss in einem Teilbereich dieser, insbesondere chemisch oder mechanisch, entfernt ist, sodass ein Teil der gegenüberliegenden zweiten Halbleiterschicht (42) als zweiter Anschluss freigelegt und kontaktierbar ist, sodass das Lasersubstrat (1) von der Seite der ersten Halbleiterschicht (41) an erstem und zweitem Anschluss kontaktierbar ist, insbesondere wobei das Lasersubstrat (1) als sogenannter Flip-Chip elektrisch leitend auf die Leiterplatte (4) oder den Lasertreiber (5) kontaktierbar ist, im Speziellen wobei der erste und zweite Anschluss mit zumindest einem Ball-Kontakt (43) versehen ist und konduktiv auf die Leiterplatte (4) oder den Lasertreiber (5) aufklebbar oder auflötbar ist.

4. Entfernungsmesser (99) nach einem der Ansprüche 1 oder 2, **dadurch gekennzeichnet, dass**
das Lasersubstrat (1) als erster Anschluss elektrisch leitend auf die Leiterplatte (4) aufgebracht ist, insbesondere geklebt, gebondet oder aufgelötet ist.

5. Entfernungsmesser (99) nach einem der Ansprüche 1 oder 2, **dadurch gekennzeichnet, dass**
das Lasersubstrat (1) als zweiter Anschluss mit einem Bonddraht (2) auf die Leiterplatte (4) kontaktiert ist.

6. Entfernungsmesser (99) nach einem der Ansprüche 1 bis 4, **dadurch gekennzeichnet, dass**
das Lasersubstrat (1) als zweiter Anschluss mit einem elektrisch leitenden Kontaktstreifen (2A), insbesondere einem Federelement, auf die Leiterplatte (4) kontaktiert ist.

7. Entfernungsmesser (99) nach einem der Ansprüche 1 bis 3, **dadurch gekennzeichnet, dass**
das Lasersubstrat (1) in einen Schlitz (50) zwischen zwei Leiterbahnen der Leiterplatte (4) eingebracht ist und seitlich jeweils zu den Leiterbahnen kontaktiert ist, insbesondere verlötet oder konduktiv verklebt ist.

8. Entfernungsmesser (99) nach einem der Ansprüche 1 bis 7, **dadurch gekennzeichnet, dass**
die Leiterplatte (4) zur Ableitung von Abwärme des Lasersubstrats (1) konfiguriert ist, insbesondere mit Leiterbahnflächen, Vias zur Ableitung in untere Leiterbahnschichten und/oder mittels eines auf der Leiterplatte (4) angebrachten Kühlkörpers.

9. Entfernungsmesser (99) nach einem der Ansprüche 1 bis 8, **dadurch gekennzeichnet, dass**
eine Kontaktierung des Halbleitersubstrats (1) derart erfolgt, dass deren Zuleitungsimpedanz gegenüber einer gehäusegekapselten Laserdiode verringert wird, insbesondere mit einer verkürzten Zuleitungslänge vom Lasertreiber zu einem elektrischen Anschluss des Lasersubstrats (1), beispielsweise durch direktes Bonding des Anschlusses des Lasersubstrats (1) auf die Leiterplatte (4) oder den Lasertreiber (5).

10. Entfernungsmesser (99) nach einem der Ansprüche 1 bis 9, **dadurch gekennzeichnet, dass**
die Sendeeinheit (23) monitordiodenlos ausgeführt ist, wobei monitordiodenlos die Lasersicherheitsrichtlinien erfüllt werden, insbesondere wobei der Lasertreiber (5) mit einer Versorgungsspannung unterhalb eines Laserthresholds des Halbleiterlasers (1) betrieben wird.

11. Sendeeinheit (23), insbesondere zum hochfrequenten Pulsbetrieb einer Laserdiode, insbesondere als vormontierte Baugruppe, für einen Entfernungsmesser (99) nach einem der vorangehenden Ansprüche 1 bis 10, mit
■ einer Leiterplatte (4) als Trägerelement,
■ einem Lasertreiber (5) als elektronischem Schaltkreis und
■ einem gehäuselosen Halbleiterlaser-Substrat (1), welches, insbesondere direkt, auf der Leiterplatte (4) aufgebracht ist.

12. Verfahren zur Herstellung einer Sendeeinheit (23) nach Anspruch 11 mit:
■ einem Aufbringen der Halbleiterlichtquelle (1) als gehäuseloses Lasersubstrat (1) auf die Leiterplatte (4), insbesondere ein direktes Aufbringen, insbesondere durch konduktives Kleben, Löten oder Friction-Bonding, und
■ einem Kontaktieren zumindest eines elektrischen Anschlusses des Lasersubstrats (1) auf die Leiterplatte (4) mittels eines Die-Bonding-Vorgangs, insbesondere mittels zumindest eines Bonddrahts (2).

13. Verfahren nach Anspruch 12, **dadurch gekennzeichnet, dass**
das Aufbringen der Halbleiterlichtquelle (1) mit einem Positionieren der Halbleiterlichtquelle (1) am Rande einer stirnseitigen Einbuchtung (9), insbesondere am Rande eines Segments einer Bohrung, der Leiterplatte (4) erfolgt.

14. Verfahren zur Reduktion einer Impedanz, insbesondere einer parasitären Zuleitungsinduktivität, einer Halbleiterlichtquelle (1) in einer Sendeeinheit (23) eines EDMs zum Aussenden von hochfrequenten, steilflankigen Lichtpulsen, **gekennzeichnet durch** ein, insbesondere direktes, Aufbringen der Halbleiterlichtquelle (1) als gehäuseloses Lasersubstrat (1) auf eine Leiterplatte (4), insbesondere **durch** konduktives Kleben, Löten oder Friction-Bonding.

15. Verfahren nach Anspruch 14, **gekennzeichnet durch** direktes Kontaktieren zumindest eines elektrischen Anschlusses des Lasersubstrats (1) auf die Leiterplatte (4) mittels eines Die-Bonding-Vorgangs, insbesondere mittels zumindest eines Bonddrahts (2).
